Europäisches Patentamt

European Patent Office

Office européen des brevets

(19)

(11) Veröffentlichungsnummer: **0 022 461**
**B1**

(12) **EUROPÄISCHE PATENTSCHRIFT**

(45) Veröffentlichungstag der Patentschrift:
**01.12.82**

(21) Anmeldenummer: **80102769.9**

(22) Anmeldetag: **20.05.80**

(51) Int. Cl.³: **H 01 L  45/00,** H 03 K  4/787

(54) **Negativer Halbleiter-Widerstand.**

(30) Priorität: **03.07.79  DE 2926757**

(43) Veröffentlichungstag der Anmeldung:
**21.01.81 Patentblatt 81/3**

(45) Bekanntmachung des Hinweises auf die Patenterteilung:
**01.12.82 Patentblatt 82/48**

(84) Benannte Vertragsstaaten:
**FR GB IT NL**

(56) Entgegenhaltungen:
**FR-A-1 210 386**
**FR-A-1 455 145**
**FR-A-2 023 722**

(73) Patentinhaber: **Licentia Patent-Verwaltungs-GmbH,**
**Theodor-Stern-Kai 1, D-6000 Frankfurt/Main 70 (DE)**

(72) Erfinder: **Dahlberg, Reinhard, Dr, Innere Bergstrasse 32,**
**D-7101 Flein (DE)**

(74) Vertreter: **Maute, Hans-Jürgen, Dipl.-Ing. et al, Licentia**
**Patent-Verwaltungs-GmbH Theodor-Stern-Kai 1,**
**D-6000 Frankfurt/Main 70 (DE)**

## Negativer Halbleiter-Widerstand

Die Erfindung beschreibt ein Bauelement mit negativem differentiellen Widerstand, der als Folge des Überschreitens der Durchbruchsfeldstärke in einem Halbleiter entsteht.

Negative differentielle Widerstände sind seit langem bei Halbleitern als Folge von lawinenartiger Trägervermehrung durch Stoss- oder Feld-Ionisation, z.B. beim Thyristor oder bei der Tunneldiode, bekannt. Beim Anlegen einer hinreichend hohen Spannung an einem homogenen Halbleiterkörper entsteht ebenfalls im Durchbruchsgebiet eine negative Strom-Spannungscharakteristik. Derartige Durchbruchsphänomene sind jedoch im allgemeinen auch mit einem lawinenartigen Ansteigen der Temperatur, der Ausbildung von Stromeinschnürungen und mit der Zerstörung der Halbleiterprobe verbunden.

Der vorliegenden Erfindung liegt die Aufgabe zugrunde, ein Bauelement anzugeben, bei dem der Durchbruch, der einen negativen Ast der Strom-Spannungscharakteristik bewirkt, ohne wesentliche Erwärmung des Halbleiters erfolgt.

Diese Aufgabe wird erfindungsgemäss dadurch gelöst, dass zwei getrennte Halbleiter-Körper mit gleichem Leitfähigkeitscharakter vorgesehen sind, dass die beiden Halbleiter-Körper unter mechanischem Druck mindestens drei definierte Berührungsstellen mit einem Durchmesser kleiner $1 \cdot 10^{-2}$ cm miteinander haben, und dass an die beiden getrennten Halbleiterkörper eine so hohe elektrische Gleich- oder Wechsel-Spannung angelegt ist, dass an den Berührungsstellen eine elektrische Feldstärke entsteht, die grösser als die Durchbruchsfeldstärke ist. Die Berührungsstellen sind vorzugsweise flächengleich und weisen eine extrem saubere Oberfläche auf.

Die beiden Halbleiterkörper sind nach einer bevorzugten Ausführungsform der Erfindung einkristallin, und die Berührungsstellen sind unter Druck bei erhöhter Temperatur in einkristalline Engewiderstände umgewandelt.

Der elektrische Widerstand $R_E$ eines derartigen Engewiderstandes ist bekanntlich $R_E = \dfrac{\varrho}{2D}$.

Dabei ist $\varrho$ der spez. elektrische Widerstand des Materials im Engewiderstand und 2D ist der Durchmesser des Engewiderstandes. Der Strom I als Funktion der am Engewiderstand liegenden Spannung U ist $I = \dfrac{U \times 2D}{\varrho}$. Die Stromdichte $S = \dfrac{U}{\varrho . 2D} \left[ \dfrac{\text{Ampere}}{\text{cm}^2} \right]$ wächst im Engewiderstand mit abnehmendem Durchmesser 2D an. Da die elektrische Feldstärke $|\varphi| = \dfrac{\text{Volt}}{\text{cm}}$ in einem Leiter $|\varphi| = S . \varrho$ ist, kann man für die elektrische Feldstärke in einem Engewiderstand schreiben $|\varphi| = \dfrac{U}{2D}$. Aus dieser Beziehung lässt sich folgern, dass man schon mit relativ kleinen Spannungen von z.B. 100 V bei Durchmessern kleiner als $10^{-3}$ cm Feldstärke in einem Enge-

widerstand von $|\varphi| \approx 10^5 \left[ \dfrac{\text{Volt}}{\text{cm}} \right]$ erzielen kann.

Dies ist generell jedoch nicht möglich, weil im allgemeinen eine unzulässige starke Erhitzung des Engewiderstandes durch Anlegen einer Spannung von 100 Volt hervorgerufen wird. Bekanntlich ist die Übertemperatur ∆T in einem Engewiderstand in erster Näherung durch die Beziehung $\Delta T = \dfrac{U^2}{8\varrho\lambda}$ beschrieben. Dabei ist U die Spannung am Engewiderstand, und λ ist die spezifische Wärmeleitfähigkeit. Wenn man fordert, dass die Übertemperatur ∆T maximal 10° betragen darf, dann ist z.B. für die Wärmeleitfähigkeit von Silizium die Spannung U auf U ≤ 0,2 Volt begrenzt bei einem spez. elektrischen Widerstand $\varrho = 10^{-3}$ Ω cm, auf etwa 6 Volt begrenzt bei einem $\varrho = 1$ Ωcm und auf 30–100 Volt begrenzt bei einem $\varrho = 10^2 - 10^3$ Ωcm. Wenn es gelingt, etwa im Rahmen dieser Spannungen zu bleiben und trotzdem – über einen entsprechend kleinen Durchmesser 2D des Engewiderstandes – die elektrische Feldstärke bis zum Durchbruch zu steigern, dann kann man mit Hilfe einer Strombegrenzung durch einen geeigneten Vorwiderstand diesen Durchbruch als rein elektrisches Geschehen ablaufen lassen.

Eine bevorzugte praktische Ausführungsform der erfindungsgemässen Anordnung sieht vor, dass die zwei getrennten Halbleiter-Körper die Form von Platten oder Scheiben haben, die jeweils auf einer Seite so strukturiert sind, dass sie eine gleichmässige Anordnung von parallel zueinander verlaufenden Wällen aufweisen, die durch Gräben voneinander getrennt sind. Die beiden Platten oder Scheiben werden mit ihren strukturierten, gegeneinander verdrehten Oberflächenseiten unter Druck und erhöhter Temperatur so zusammengepresst, dass die sich berührenden Wälle kreuzen und eine flächenhafte Verteilung von zahlreichen elektrisch parallel geschalteten Engewiderständen zwischen den beiden Platten oder Scheiben bilden.

Das Prinzip der gekreuzten parallelen Wälle ist bereits in der Offenlegungsschrift P 25 47 262 beschrieben worden. Es wird dort jedoch nicht ausgeführt, dass und wie ein negativer Halbleiter-Widerstand nach diesem Prinzip hergestellt werden kann.

Die beiden Halbleiter-Körper bestehen vorzugsweise aus einkristallinen Element- oder Verbindungshalbleitern mit n-, p- oder intrinsic-Leitfähigkeit.

Der negative Halbleiter-Widerstand lässt sich mit Vorteil als Sägezahn-Generator verwenden. Er wird mit einem ohmschen Vorwiderstand betrieben, welcher vorzugsweise kleiner als der Gesamtwiderstand aller parallel geschalteten Engewiderstände ausserhalb des elektrischen Durchbruches ist.

Es können auch mehrere Negative Halbleiter-Widerstände elektrisch in Serie geschaltet werden.

Die beiden getrennten Halbleiter-Körper haben ohmsche Kontakte für den äusseren elektrischen Anschluss.

Die Halbleiter-Körper können so ausgebildet sein, dass ihr Bahnwiderstand gleichzeitig als ohmscher Vorwiderstand verwendbar ist.

Elektrisch parallel zum negativen Halbleiter-Widerstand kann ein elektrischer Kondensator geschaltet sein.

Der ohmsche Vorwiderstand und der parallel geschaltete Kondensator können variierbar ausgebildet sein.

Der negative Halbleiter-Widerstand der Erfindung kann auch mit Vorteil als Schalter verwendet werden.

Die Erfindung wird im folgenden mit 3 Ausführungsbeispielen erläutert.

Ausführungsbeispiel 1 beschreibt einen einzelnen Halbleiter-Engewiderstand.

Ausführungsbeispiel 2 beschreibt einen negativen Halbleiter-Widerstand mit einer Vielzahl paralleler Engewiderstände.

Ausführungsbeispiel 3 beschreibt schematisch den negativen Halbleiter-Widerstand als Sägezahn-Generator.

Ausführungsbeispiel 1

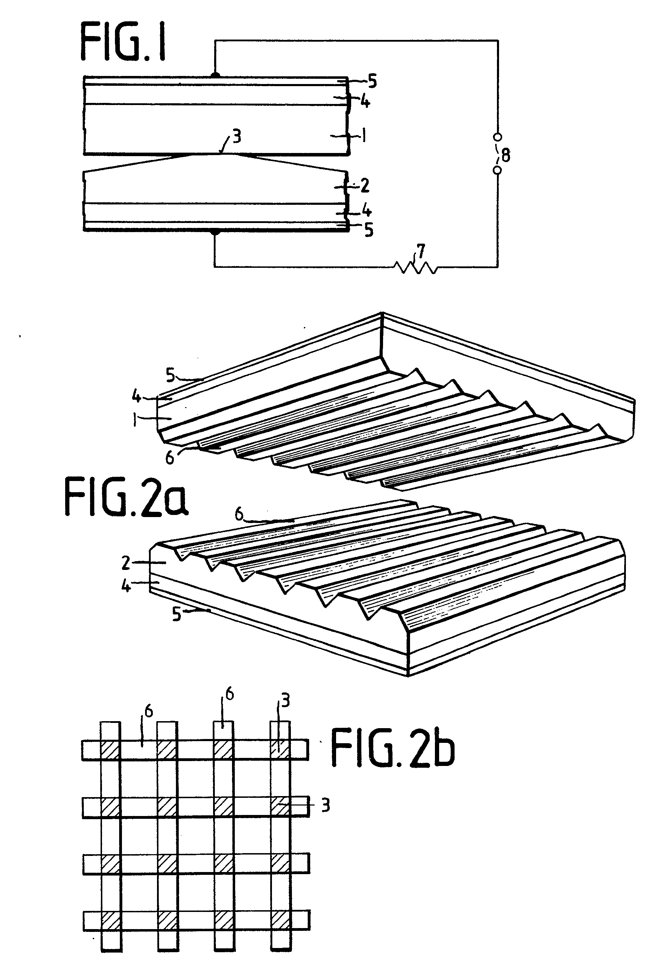

In Fig. 1 sind 1 und 2 die zwei getrennten Halbleiter-Körper mit gleichem Leitfähigkeitscharakter. 3 ist die kleinflächige Berührungsstelle der beiden Halbleiter-Körper. Diese Berührungsstelle wird durch die Oberfläche einer wall- oder mesaförmigen Erhebung auf dem scheibenförmigen Halbleiter-Körper 2 bestimmt. 4 sind hochdotierte Halbleiterschichten an den beiden Halbleiter-Körpern auf deren der Berührungsstelle abgewandten Oberflächenseiten, wobei der Leitfähigkeitstyp dieser Schichten mit dem der Halbleiter-Körper übereinstimmt. 5 sind an die hochdotierten Halbleiterschichten angebrachte Metallkontakte. Die beiden Metallkontakte sind über einen Vorwiderstand 7 mit der Spannungsquelle 8 verbunden.

Ausführungsbeispiel 2

In Fig. 2a haben die beiden Halbleiter-Körper 1 und 2 die Form von einkristallinen Silizium-Scheiben, welche auf einer ihrer beiden Seiten eine Struktur von parallel zueinander verlaufenden Wällen 6 mit dazwischenliegenden Gräben haben. 4 sind hochdotierte Halbleiterschichten auf den den strukturierten Oberflächen gegenüberliegenden Oberflächenseiten und 5 sind die Metallkontakte an diesen hochdotierten Schichten. Die Scheibe 1 wird auf die Strukturen bezogen um einen Winkel von 90° in der Scheibenebene gedreht auf die Scheibe 2 aufgesetzt. Dadurch überkreuzen und berühren sich die Wälle 6. Durch Druck bei erhöhter Temperatur wandeln sich die Berührungsstellen 3 (siehe Darstellung der Berührungsebene gemäss Fig. 2b) in einkristalline Engewiderstände um.

Ausführungsbeispiel 3

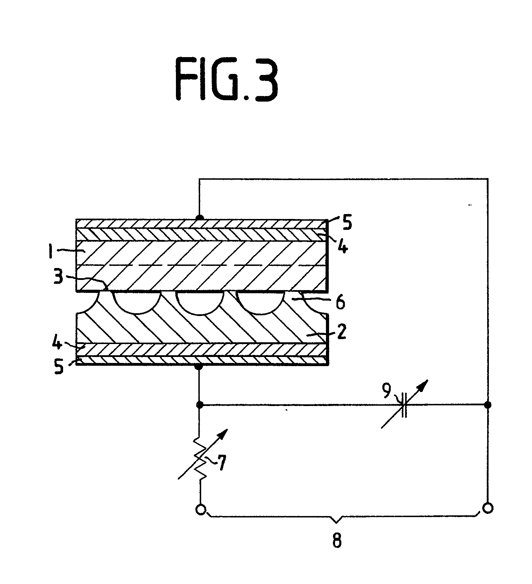

In der Schnittdarstellung der Fig. 3 sind 1 und 2 zwei einkristalline 1.000 $\Omega$cm n-Silizium-Scheiben von $0,5 \times 0,5$ cm$^2$ Fläche, welche über n$^+$-Schichten 4 und Metall-Kontakte 5 sperrfrei kontaktiert sind. Beide Scheiben haben eine Dicke von 0,1 cm und tragen auf einer ihrer Seiten eine Struktur von parallelen Wällen 6, welche einen Abstand von $5 \cdot 10^{-3}$ cm haben. An der mit der Stirnseite zusammenfallenden schmalsten Stelle haben die Wälle 6 nur eine Breite von $5 \cdot 10^{-5}$ cm. Beide Scheiben sind bezüglich der Wallstrukturen gegeneinander in der Ebene verdreht unter Druck aufeinandergelegt. Durch die sich überkreuzenden Wälle 6 werden $4 \cdot 10^4$ Berührungstellen 3 gebildet, die bei erhöhter Temperatur in einkristalline Engewiderstände 3 umgewandelt werden. Jeder Engewiderstand 3 hat ca. $4 \cdot 10^7$ Ohm. Die gesamte Anordnung hat einen Widerstand von etwa $10^3$ Ohm. Über den Vorwiderstand 7 von ebenfalls $10^3$ Ohm kann die Gleichspannungsquelle 8 mit > 100 Volt an die sperrfreien Kontakte 5 des negativen Halbleiter-Widerstandes angeschlossen werden. Wenn die Spannung am parallel zum negativen Widerstand geschalteten Kondensator 9 den Wert 100 Volt erreicht, dann steht an den Engewiderständen 3 eine elektrische Feldstärke von grösser $10^5$ Volt/cm (im Silizium) und der Widerstand der Engewiderstände 3 bricht zusammen, so dass sich der Kondensator 9 entladen kann. Der gesamte Leistungsverbrauch der Anordnung von etwa 10 Watt wird zu fast 50% in Leistung der Sägezahnschwingung umgewandelt. Für die Frequenz der Sägezahnschwingung ist das Produkt aus Vorwiderstand 7 und Kondensator 9 massgeblich. Daher wird der Vorwiderstand 7 und der Kondensator 9 vorzugsweise in den elektrischen Werten variabel ausgebildet.

Bezugsziffern
1 Halbleiter-Körper 1
2 Halbleiter-Körper 2
3 Berührungsstelle zwischen 1 und 2
4 hochdotierte Halbleiterschicht
5 Metallkontakt
6 parallele Wälle
7 elektrischer Widerstand
8 elektrische Gleich- oder Wechselspannung
9 elektrischer Kondensator

**Patentansprüche**

1. Negativer Halbleiter-Widerstand, dadurch gekennzeichnet, dass zwei getrennte Halbleiter-Körper (1, 2) mit gleichem Leitfähigkeitscharakter vorgesehen sind, dass die beiden Halbleiter-Körper unter mechanischem Druck mindestens drei definierte Berührungsstellen (3) mit einem Durchmesser kleiner $1 \cdot 10^{-2}$ cm miteinander haben, und dass an die beiden getrennten Halbleiter-Körper (1, 2) eine so hohe elektrische Gleich- oder Wechselspannung (8) angelegt ist, dass an den Berührungsstellen (3) eine elektrische Feldstärke entsteht, welche grösser als die Durchbruchsfeldstärke ist.

2. Negativer Halbleiter-Widerstand nach Anspruch 1, dadurch gekennzeichnet, dass die Berührungsstellen (3) flächengleich sind.

3. Negativer Halbleiter-Widerstand nach einem der vorhergehenden Ansprüche, dadurch gekennzeichnet, dass die Halbleiter-Körper (1, 2) einkristallin sind, und dass die Berührungsstellen (3) unter Druck bei erhöhter Temperatur in einkristalline Engewiderstände (3) umgewandelt sind.

4. Negativer Halbleiter-Widerstand nach einem der vorhergehenden Ansprüche, dadurch gekennzeichnet, dass die zwei getrennten Halbleiter-Körper (1, 2) die Form von Platten oder Scheiben haben, die jeweils auf einer Seite so strukturiert sind, dass sie eine gleichmässige Anordnung von parallelen Wällen (6) aufweisen und dass die beiden strukturierten Seiten mit einer sauberen Halbleiter-Oberfläche unter Druck und erhöhter Temperatur so zusammengedrückt sind, dass die sich kreuzenden und berührenden Wälle (6) eine flächenhafte Verteilung von elektrisch parallel geschalteten Engewiderständen (3) zwischen den beiden Platten oder Scheiben (1, 2) bilden.

5. Negativer Halbleiter-Widerstand nach einem der vorhergehenden Ansprüche, dadurch gekennzeichnet, dass die beiden Halbleiter-Körper (1, 2) einkristalline Element- oder Verbindungs-Halbleiter mit n-, p- oder intrinsic-Leitfähigkeit sind.

6. Negativer Halbleiter-Widerstand nach einem der vorhergehenden Ansprüche, gekennzeichnet durch seine Verwendung für einen Halbleiter-Sägezahn-Generator.

7. Negativer Halbleiter-Widerstand nach einem der vorhergehenden Ansprüche, gekennzeichnet, durch seine Verwendung als Schalter.

8. Negativer Halbleiter-Widerstand nach einem der vorhergehenden Ansprüche, dadurch gekennzeichnet, dass er mit einem ohmschen Vorwiderstand verbunden ist, welcher vorzugsweise kleiner als der Gesamtwiderstand aller parallel geschalteten Engewiderstände ausserhalb des elektrischen Durchbruchs ist.

9. Negativer Halbleiter-Widerstand nach einem der vorhergehenden Ansprüche, dadurch gekennzeichnet, dass die zwei getrennten Halbleiter-Körper (1, 2) ohmsche Anschluss-Kontakte (4, 5) haben.

10. Negativer Halbleiter-Widerstand nach einem der Ansprüche 8 oder 9, dadurch gekennzeichnet, dass die zwei getrennten Halbleiter-Körper (1, 2) so dick sind, dass ihr Bahnwiderstand den ohmschen Vorwiderstand bildet.

11. Negativer Halbleiter-Widerstand, dadurch gekennzeichnet, dass mehrere negative Halbleiter-Widerstände nach einem der vorhergehenden Ansprüche elektrisch in Serie geschaltet sind.

12. Anordnung mit einem negativen Halbleiter-Widerstand nach einem der vorhergehenden Ansprüche, dadurch gekennzeichnet, dass parallel zu dem negativen Halbleiter-Widerstand (7) ein elektrischer Kondensator (9) geschaltet ist.

13. Anordnung nach Anspruch 12, dadurch gekennzeichnet, dass der ohmsche Vorwiderstand (7) und der Parallel-Kondensator (9) in den elektrischen Werten variierbar sind.

## Revendications

1. Résistance négative à semiconducteurs, caractérisée en ce que deux substrats semiconducteurs distincts (1, 2), de même type de conductibilité, son prévus; les deux substrats semiconducteurs présentent sous pression mécanique au moins trois points de contact (3) définis, d'un diamètre inférieur à $1.10^{-2}$ cm; et une tension électrique (8), continue ou alternative, est appliquée aux deux substrats semiconducteurs (1, 2) distincts, avec une amplitude telle que le champ électrique produit est supérieur au champ de claquage.

2. Résistance négative à semiconducteurs selon revendication 1, caractérisée en ce que les points de contact (3) présentent la même superficie.

3. Résistance négative à semiconducteurs selon une des revendications 1 et 2, caractérisée en ce que les substrats semiconducteurs (1, 2) sont monocristallins; et les points de contact (3) sont transformés sous pression et à température élevée en résistances de pincement monocristallines (3).

4. Résistance négative à semiconducteurs selon une quelconque des revendications 1 à 3, caractérisée en ce que les deux substrats semiconducteurs (1, 2) distincts sont des plaquettes dont une face est structurée de façon à présenter une disposition régulière de protubérances (6) parallèles; et les deux faces structurées, présentant une surface propre, sont assemblées sous pression et à température élevée de façon que les protubérances (6) croisées et en contact forment une distribution surfacique de résistances de pincement (3) branchées électriquement en parallèle entre les deux plaquettes (1, 2).

5. Résistance négative à semiconducteurs selon une quelconque des revendications 1 à 4, caractérisée en ce que les deux substrats semiconducteurs (1, 2) sont des semiconducteurs intrinsèques ou des composés intermétalliques, monocristallins et de conductibilité n, p ou intrinsèque.

6. Résistance négative à semiconducteurs selon une quelconque des revendications 1 à 5, caractérisée par son utilisation dans un générateur de dents de scie à semiconducteurs.

7. Résistance négative à semiconducteurs selon une quelconque des revendications 1 à 6, caractérisée par son utilisation comme interrupteur.

8. Résistance négative à semiconducteurs selon une quelconque des revendications 1 à 7, caractérisée par sa liaison avec une résistance additionnelle pure, avantageusement inférieure à la résistance totale de toutes les résistances de pincement branchées en parallèle, en dehors du claquage électrique.

9. Résistance négative à semiconducteurs selon une quelconque des revendications 1 à 8, caractérisée en ce que les deux substrats semiconducteurs (1, 2) distincts présentent des contacts de connexion ohmiques (4, 5).

10. Résistance négative à semiconducteurs selon une des revendications 8 ou 9, caractérisée en ce que l'épaisseur des deux substrats semiconducteurs (1, 2) distincts est telle que leur résistance volumique constitue la résistance additionnelle pure.

11. Résistance négative à semiconducteurs, caractérisée par le branchement électrique en série de plusieurs résistances négatives à semiconducteurs selon une quelconque des revendications 1 à 10.

12. Montage comportant une résistance négative à semiconducteurs selon une quelconque des revendications 1 à 11, caractérisée par le branchement d'un condensateur (9) en parallèle avec la résistance négative à semiconducteurs (7).

13. Montage selon revendication 12, caractérisée en ce que la résistance additionnelle pure (7) et le condensateur (9) en parallèle sont variables.

## Claims

1. A negative semiconductor resistor characterised in that there are provided two separate semiconductor bodies (1, 2) with the same conductivity characteristics; that both semiconductor bodies have at least three fixed areas of contact (3), with a diameter of less than $1.10^{-2}$ cm under mechanical pressure; and that an electrical d.c. or a.c. voltage (8) is applied to the tow separate semiconductor bodies (1, 2), the said voltage (8) being so high that an electrical field strength greater than the breakdown field strength is formed at these areas of contact (3).

2. A negative semiconductor resistor according to claim 1, characterised in that the areas of contact (3) are equal in area.

3. A negative semiconductor resistor according to any one of the preceding claims characterised in that the semiconductor bodies (1, 2) are monocrystalline and that the areas of contact (3) are transformed under pressure into monocrystalline narrow resistors (3) at an elevated temperature.

4. A negative semiconductor resistor according to any one of the preceding claims characterised in that the two separate semiconductor bodies (1, 2) have the shape of plates or discs which are structured on one side in each case so that they have a uniform arrangement of parallel ridges (6), and that the two structured sides having a clean semiconductor surface are pressed together under pressure and at an elevated temperature so that the crossing and touching ridges (6) form a surface distribution of electrically parallel connected narrow resistors (3) between the tow plates or discs (1, 2).

5. A negative semiconductor resistor according to any one of the preceding claims, characterised in that the two semiconductor bodies (1, 2) are monocrystalline elements-or compound-semiconductor having n, P or instrinic conductivity.

6. A negative semiconductor resistor according to any one of the preceding claims, characterised by its use for a semiconductor saw tooth generator.

7. A negative semiconductor resistor according to any one of the preceding claims, characterised by its use as a switch.

8. A negative semiconductor resistor according to any one of the preceding claims, characterised in that it is connected to an ohmic series resistor which is preferably smaller than the overall resistance of all of the parallel connected narrow resistors except for the electrical breakdown.

9. A negative semiconductor resistor according to any one of the preceding claims, characterised in that the two separate semiconductor elements (1, 2) have ohmic connection contacts (4, 5).

10. A negative semiconductor resistor according to claims 8 or 9 characterised in that the two separate semiconductor elements (1, 2) are so thick that their bulk resistance forms the ohmic series resistance.

11. A negative semiconductor resistance characterised in that several negative semiconductor resistors according to any one of the preceding claims are connected electrically in series.

12. An arrangement with a negative semiconductor resistor according to any one of the preceding claims, characterised in that an electrical capacitor (9) is connected in parallel with the negative semiconductor resistor (7).

13. An arrangement according to claim 12 characterised in that the ohmic series resistor (7) and the parallel capacitor (9) may have their electrical values varied.

# FIG.1

# FIG.2a

# FIG.2b

# FIG.3